# EUROPÄISCHE PATENTSCHRIFT

(11) **EP 3 315 852 B1**
(45) Veröffentlichungstag und Bekanntmachung des Hinweises auf die Patenterteilung: **08.04.2020**
(21) Anmeldenummer: 17192426.9
(22) Anmeldetag: 21.09.2017
(51) Int. Cl.: F21S 41/16, G01N 21/00, H01S 5/00

(54) **LASER ACTIVATED REMOTE PHOSPHOR SYSTEM UND FAHRZEUGSCHEINWERFER**
LASER ACTIVATED REMOTE PHOSPHOR SYSTEM AND VEHICLE HEADLAMP
SYSTÈME DE PHOSPHORE ACTIVÉ À DISTANCE PAR LASER ET PROJECTEUR DE VÉHICULE

(30) Priorität: 25.10.2016 DE 102016220917
(43) Veröffentlichungstag der Anmeldung: 02.05.2018
(73) Patentinhaber: OSRAM Beteilungsverwaltung GmbH, 82031 Grünwald (DE)
(72) Erfinder: Sorg, Joerg, 93053 Regensburg (DE)
(74) Vertreter: Paul, Benjamin

(56) Entgegenhaltungen:
- WO-A1-2012/128384
- JP-A- 2013 102 078
- US-A1- 2014 369 064

## Beschreibung

Die Erfindung geht aus von einem Laser Activated Remote Phosphor (LARP) System gemäß dem Oberbegriff des Anspruchs 1 und von einem Fahrzeugscheinwerfer.

Bei dem LARP System wird ein von einer Strahlungsquelle beabstandet angeordnetes Konversionselement, das einen Leuchtstoff aufweist oder daraus besteht, mit einer Anregungsstrahlung, insbesondere einem Anregungsstrahl (Pumpstrahl, Pumplaserstrahl) bestrahlt, insbesondere mit dem Anregungsstrahl einer Laserdiode. Die Anregungsstrahlung des Anregungsstrahls wird vom Leuchtstoff zumindest teilweise absorbiert und zumindest teilweise in eine Konversionsstrahlung umgewandelt, deren Wellenlängen und somit spektralen Eigenschaften und/oder Farbe durch die Konversionseigenschaften des Leuchtstoffs bestimmt wird. Beispielsweise kann so mit Hilfe des Konversionselements blaue Anregungsstrahlung (blaues Laserlicht) in rote und/oder grüne und/oder gelbe Konversionsstrahlung (Konversionslicht) konvertiert werden. So ein System wird auch als Laser Activated Remote Phosphor System (LARP) bezeichnet.

Konversionslicht und gegebenenfalls unkonvertiertes Anregungslicht bilden das Nutzlicht. Beispielsweise im Falle der Verwendung einer blauen Laserdiode, mit einer Anregungsstrahlung im Wellenlängenbereich von etwa 440 bis 470 nm, und eines in Konversionsstrahlung des gelben Wellenlängenbereichs konvertierendes Konversionselement, beispielsweise bestehend aus Cer-dotiertem Yttrium-Aluminium-Granat, also Ce:YAG, ergibt sich mit abnehmenden Zumischungsanteil einer unkonvertierten Laserstrahlung zum Konversionslicht ein bläuliches, weißbläuliches, weißes, weiß-gelbliches oder gelbes Nutzlicht. Die Farbkoordinaten des Nutzlichts liegen im Automotive-Bereich bevorzugt im genormten ECE-Weißfeld gemäß der Richtlinie ECE/324/Rev.1/Adb.47/Reg.No.48/Rev.12.

Dabei hat es sich gezeigt, dass diese Blau-Gelb-Farbverschiebung des Nutzlichtes zu sogenannten Blau-Gelb-Ringen auf der Nutzlichtseite des Konversionselements führt. Die Mittenstrahlung ist blau überhöht, und die Außenstrahlung gelb überhöht, was dazu führt, dass sich bei einem symmetrischen Anregungsstrahlungsprofil auf der Abstrahlseite des Konversionselements blau-gelbe Ringe ausbilden. Als Folge davon ergibt sich auch in den vorgesehenen Anwendungen eine blau-gelbe Ringproblematik bzw. Farbvarianzen der zu bestrahlenden Flächen (Straße, Wand), die jedoch in Fahrzeugscheinwerfern oder Effektleuchten unerwünscht sind.

Derartige LARP Systeme werden beispielsweise als Lichtquellen in Fahrzeugscheinwerfern oder Projektionsanwendungen eingesetzt. Zum Fokussieren der Anregungsstrahlung auf das Konversionselement können geeignete optische Systeme vorgesehen sein.

Es hat sich gezeigt, dass ein Farbortgang, also eine Ortsabhängigkeit des Farbortes, über die Lichtaustrittsfläche des Konversionselements vorliegt. Darüber hinaus kann ein Farbortgang über den Betrachtungswinkel gesehen auftreten, also eine Winkelabhängigkeit des Farbortes. Wird das LARP System beispielsweise bei dem Fahrzeugscheinwerfer eingesetzt, so wird dieses üblicherweise mit optischen Elementen, wie beispielsweise Reflektoren und Linsen, kombiniert. Eine Projektion des farblich inhomogenen Nutzlichts in einen Ausleuchtungsbereich resultiert dann in einem Farbortgang im Ausleuchtungsbereich. Die Inhomogenität des Nutzlichts im Ausleuchtungsbereich ist hierbei unerwünscht.

Die Aufgabe der vorliegenden Erfindung ist es, ein LARP System und einen Fahrzeugscheinwerfer zu schaffen, die vorrichtungstechnisch einfach und kostengünstig ausgestaltet sind und bei denen Nutzlicht vergleichsweise homogen emittiert ist, also eine geringe Ortsabhängigkeit des Farbortes auf der im LAPR-System genutzten Emissionsseite des Konversionselements vorliegt.

Diese Aufgabe wird gelöst hinsichtlich des LARP Systems gemäß den Merkmalen des Anspruchs 1 und hinsichtlich des Fahrzeugscheinwerfers gemäß den Merkmalen des Anspruchs 15.

Besonders vorteilhafte Ausgestaltungen finden sich in den abhängigen Ansprüchen.

Erfindungsgemäß ist ein Laser activated Remote Phosphor (LARP) System mit einer Strahlungsquelle vorgesehen, über die eine Anregungsstrahlung emittierbar ist. Bei der Anregungsstrahlung handelt es sich beispielsweise um blaues Laserlicht. Des Weiteren kann das System ein Konversionselement aufweisen, das wiederum einen Leuchtstoff hat oder daraus zumindest im Wesentlichen oder vollständig besteht.

scheinwerfer eingesetzt, so wird dieses üblicherweise mit optischen Elementen, wie beispielsweise Reflektoren und Linsen, kombiniert. Eine Projektion des farblich inhomogenen Nutzlichts in einen Ausleuchtungsbereich resultiert dann in einem Farbortgang im Ausleuchtungsbereich. Die Inhomogenität des Nutzlichts im Ausleuchtungsbereich ist hierbei unerwünscht.

Die WO 2012/128384 A1 offenbart einen Frontscheinwerfer mit einer Laserlichtquelle und einer Lichtemissionseinheit zur Emission von mittels der Laserlichtquelle angeregtem Fluoreszenzlicht, wobei die Größe eines von der Laserlichtquelle erzeugten und auf die Lichtemissionseinheit gerichteten Laserspots größer ist als die Oberfläche der Lichtemissionseinheit.

Die US 2014/369064 A1 offenbart einen Lichtemitter mit einem lichtemittierenden Abschnitt, der als Folge von auf eine Oberfläche des lichtemittierenden Abschnitts auftreffenden Anregungslichts Fluoreszenzlicht emittiert, und mit einem Reflektor, der einen lichtemittierenden Bereich auf der auf der Oberfläche des lichtemittierenden Abschnitts definiert, wobei das Fluoreszenzlicht vom lichtemittierenden Bereich emittiert wird und das Anregungslicht eine hutförmige Energieintensitätsverteilung auf der Oberfläche des lichtemittierenden Abschnitts hat.

Die JP 2013-102078 A offenbart eine Halbleiterlichtquelle, die Licht mit einer bestimmten Wellenlänge aus dem Spektralbereich des sichtbaren Lichts als Anregungslicht emittiert, und eine Leuchtstoffplatte mit mindestens einem Leuchtstoff, der vom Anregungslicht zur Emission von Fluoreszenzlicht stimuliert wird, dessen Wellenlänge länger als die Wellenlänge des Anregungslichts ist, wobei die Leuchtstoffplatte mit Abstand zur Halbleiterlichtquelle angeordnet ist und in eine Vielzahl von Bereichen aufgeteilt ist, deren Abmessungen jeweils kleiner als die Lichtspotgröße des Anregungslichts ist.

Die Aufgabe der vorliegenden Erfindung ist es, ein LARP System und einen Fahrzeugscheinwerfer zu schaffen, die vorrichtungstechnisch einfach und kostengünstig ausgestaltet sind und bei denen Nutzlicht vergleichsweise homogen emittiert ist, also eine geringe Ortsabhängigkeit des Farbortes auf der im LAPR-System genutzten Emissionsseite des Konversionselements vorliegt.

Diese Aufgabe wird gelöst hinsichtlich des LARP Systems gemäß den Merkmalen des Anspruchs 1 und hinsichtlich des Fahrzeugscheinwerfers gemäß den Merkmalen des Anspruchs 7.

Besonders vorteilhafte Ausgestaltungen finden sich in den abhängigen Ansprüchen.

Erfindungsgemäß ist ein Laser activated Remote Phosphor (LARP) System mit einer Strahlungsquelle vorgesehen, über die eine Anregungsstrahlung emittierbar ist. Bei der Anregungsstrahlung handelt es sich beispielsweise um blaues Laserlicht. Des Weiteren umfasst das System ein Konversionselement, das wiederum einen Leuchtstoff hat oder daraus zumindest im Wesentlichen oder vollständig besteht.

Die Anregungsstrahlung der Strahlungsquelle weist in etwa eine symmetrische Intensitätsverteilung auf, die jedoch in unterschiedlichen Richtungen parallel zur Bestrahlungsfläche des Konversionselement unterschiedliche Intensitätsverteilungen aufweisen kann. Als zentraler Bereich eines Anregeflecks der Anregungsstrahlung wird im Folgenden ein eingangsseitiger Flächenbereich auf dem Konversionselement definiert, in dem die Intensität der Anregungsstrahlung noch nicht auf einen bestimmten Wert - bezogen auf den Mittenbereich der Anregungsstrahlung - abgefallen ist, beispielsweise auf den Wert von 1/e der axialen Mittenstrahlung, oder alternativ auf 1/e² oder alternativ auf einen anderen frei wählbaren Wert. Diese Werte können je nach Orientierungsrichtung parallel zur eingangsseitigen Oberfläche des Konversionselements unterschiedlich definiert bzw. eingestellt werden, so zum Beispiel durch Strahlformung des Laserspots.

Der zentrale Anregefleck wird dabei so eingestellt, zum Beispiel durch ein strahlformendes optisches Element, dass er zumindest bereichsweise das Konversionselement überstrahlt, also zumindest abschnittsweise eine eingangsseiige Begrenzungslinie des Konversionselements überschreitet, also den Rand der sichtbaren Fläche des Konversionselements zumindest abschnittsweise überstrahlt.

Das Konversionselement kann in einer transmissiven Anordnung verwendet werden, wo also die Laser-Anregunsstrahlung auf der einen Fläche und die Nutzstrahlung auf der gegenüberliegende Fläche des Konversionselement eingestrahlt bzw. abgestrahlt werden. In einer reflektiven Anordnung werden die Laser-Anregungsstrahlung und die Nutzstrahlung auf derselben Fläche des Konversionselement eingestrahlt bzw. abgestrahlt.

Optional kann der Anregefleck der Anregungsstrahlung durch eine mechanische Blende begrenzt werden, welche direkt an der Einstrahlfläche des Konversionselements oder nahe beabstandet zur dieser dergestalt angebracht ist, dass nur der zentrale Anregefleck auf das Konversionselement fällt und dieses zumindest bereichsweise überstrahlt, also zumindest abschnittsweise eine Begrenzungslinie des Konversionselements überschreitet. Die optionale Blende kann dabei rund, elliptisch oder freiförmig ausgeführt sein.

Der zentrale Anregefleck der Anregungsstrahlung überschreitet dabei zumindest abschnittsweise eine Begrenzungslinie oder Umfangslinie einer Einkoppelfläche des Konversionselements, insbesondere etwa in einer Ebene gesehen, die sich etwa senkrecht zur Hauptabstrahlachse des Konversionselements erstreckt. Die Begrenzungslinie kann zum Beispiel durch mechanisches Einfassen der Konversionselements ausgebildet werden. Die Anregungsstrahlung kann dabei beispielsweise etwa senkrecht auf das Konversionselement treffen. Der zentrale Anregungsfleck liegt somit zumindest teilweise außerhalb der Konversionsfläche des Konversionselements.

Diese Lösung hat den Vorteil, dass die Geometrie des Konversionselements und die Geometrie des zentralen Anregeflecks aufeinander abgestimmt sind. Es hat sich gezeigt, dass in den Bereichen, in denen der zentrale Anregefleck die Begrenzungslinie des Konversionselements zumindest abschnittsweise überstrahlt, eine Homogenität eines abgestrahlten Nutzlichts verbessert ist. Diese Homogenität kann beispielsweise als Ortsvarianz der Cx- bzw. Cy- Farbraumwerte (CIE) vom Mittenbereich der Nutzstrahlung zu einem Außenbereich der Nutzstrahlung auf der Abstrahlfläche des Konversionselements gemessen werden. Durch die hier beschriebene Vorrichtung bzw. Bestrahlungsmethode ist es möglich, die jeweilige Farb-Varianz Cx bzw. Cy gering zu halten, beispielsweise im jeweiligen Wertebereich zwischen 5% und 30 %. Dadurch ist es auf einfache Weise möglich, das eingangs erwähnte Blau-Gelb-Homogenitätsproblem zu verbessern oder sogar weitestgehend zu minimieren.

Dagegen ist es im Stand der Technik üblich, dass eine räumliche Ausdehnung des Konversionselements etwa senkrecht zur Anregungsrichtung größer als der zentrale Anregefleck ist und dieser somit die Einstrahlfläche des Konversionselements nicht vollständig ausfüllt. Aus einer Auskoppelfläche oder Lichtaustrittsfläche des Konversionselements tritt dann im Bereich, welcher vom zentralen Anregefleck bestrahlt wird, ein höherer Anteil von nicht konvertierter Anregungsstrahlung im Vergleich zum Randbereich aus, welcher von Anregungsstrahlung bestrahlt wird, die von einem Anregefleck emittiert wird, der zumindest teilweise außerhalb des zentralen Anregeflecks liegt. Umgekehrt wird im Randbereich des Konversionselements ein höherer Anteil von konvertierter Anregungsstrahlung im Vergleich zum zentralen Bereich emittiert. Bei der Winkelverteilung ergibt sich ein ähnlicher Effekt für die austretenden Spektren, also für das transmittierte Anregungsspektrum und das konvertierte Spektrum. Im zentralen Bereich des Konversionselements tritt im Stand der Technik aus der Auskoppelfläche hierbei nicht konvertierte Anregungsstrahlung mit einer aufgrund geringerer Streueffekte höheren Direktionalität bzw. geringerer Winkeldivergenz aus, während im Randbereich die Winkelverteilung durch eine größere Anzahl an Streueffekten und durch eine größere zurückgelegte Weglänge der Anregungsstrahlung im Konversionselement breiter ist. Ähnliche Effekte treten auch bei der konvertierten Strahlung auf. Eine derartige Konfiguration führt somit zu den eingangs angeführten Farbortgängen, also einem blauen-überhöhten Zentrum und einem gelben Außenbereich.

Mit dem erfindungsgemäßen LARP System ist somit vorgesehen, dass in den Bereichen, bei denen der zentrale Anregefleck über die Begrenzungslinie des Konversionselements hinaus strahlt, Flächeninkremente bzw. Flächenbereiche der Auskoppelfläche in diesen Bereichen etwa das selbe Verhältnis von nicht konvertierter Anregungsstrahlung (Anregungsspektrum, Teiltransmission) und konvertierter Strahlung (Konversionsspektrum, Konversion) im Vergleich zum mittigen Bereich des Konversionselements aufweisen. Das gleiche gilt für die Winkelverteilungen der nicht konvertierten Anregungsstrahlung und der konvertierten Strahlung in diesen Bereichen im Vergleich zum mittigen Bereich.

Diese Lösung hat des Weiteren den Vorteil, dass das Nutzlicht bereits an der Auskoppelfläche des Konversionselements eine vergleichsweise hohe Homogenität aufweist und somit eine vergleichsweise hohe homogene Mischung hat. Dies führt dazu, dass in einem möglichen optischen System im Nachgang des LARP Systems keine weiteren oder nur Vorkehrungen im geringeren Maß zur Lichtmischung im Vergleich zum Stand der Technik vorgesehen werden müssen ("Ease of use"). Für das mögliche optische System ergeben sich somit zusätzliche Freiheitsgrade beim Bauraum, bei einer Größe einer oder mehrerer Optiken und/oder bei einer Umsetzung vorteilhafter Kontraste (Hell-Dunkelgrenze). Des Weiteren ist bei der erfindungsgemäßen Lösung ein Effizienzverlust verringert oder tritt im Wesentlichen nicht auf, da im Vergleich zum Stand der Technik zur Verbesserung der Effizienz keine Ausblendung unerwünschter Bereiche des Nutzlichts vorgesehen ist oder auf ein Einbringen von Streuelementen in einen Strahlengang des Nutzlichts verzichtet wird.

Der zentrale Anregefleck überschreitet somit zumindest abschnittweise eine Randlinie des Konverterelements bzw. des vorgesehenen Konversionsbereiches. Somit kann eine Form und Größe des zentralen Anregeflecks derart gewählt sein, dass dieser zumindest abschnittsweise über das Konversionselement hinausgeht. Die Größe kann hierbei eine geometrische Ausdehnung des konvertierenden Bereichs und des Anregeflecks beispielsweise senkrecht zur Anregungsrichtung beschreiben. Mit dieser Ausgestaltung wird auf vorrichtungstechnisch einfache Weise das Nutzlicht homogenisiert. Vorzugsweise ist der zentrale Anregefleck etwa kreisförmig ausgestaltet, kann aber auch elliptisch oder polygonal oder freiförmig ausgestaltet sein. Des Weiteren ist vorteilhaft, wenn der der zentrale Anregefleck und das Konversionselement etwa koaxial zueinander angeordnet sind, was zu einer verbesserten Homogenität führt.

Gemäß der Erfindung ist ein Durchstrahlelement vorgesehen. Dieses umgreift hierbei vorrichtungstechnisch einfach das Konversionselement. Das Durchstrahlelement und das Konversionselement können hierbei verbunden sein. Das Umgreifen erfolgt beispielsweise abschnittsweise oder im Wesentlichen vollständig oder vollständig. Insbesondere erfolgt das Umgreifen umfangsseitig des Konversionselements, indem das Konversionselement an seinem Rand umgriffen ist. Somit kann dann die Einkoppelfläche von dem Durchstrahlelement umfasst sein. Gemäß der Erfindung ist das Durchstrahlelement ringförmig bzw. ringsegmentförmig ausgestaltet, kann aber auch gemäß einer nicht beanspruchten Ausführungsform kegelstumpfförmig oder freiförmig ausgestaltet sein. Bei einer kegelstumpfförmigen Ausgestaltung des Durchstrahlelements kann der eingangsseitige Durchmesser größer als der gegenüberliegende ausgangsseitige Durchmesser sein. Das Durchstrahlelement kann insbesondere für die Anregungsstrahlung oder für das Anregungsspektrum transparent oder teiltransparent ausgestaltet sein und kann alternativ oder zusätzlich streuend sein. Das Durchstrahlelement besteht vorzugsweise zumindest im Wesentlichen vollständig oder vollständig aus einem für die Anregungsstrahlung transparenten oder teiltransparenten und/oder streuenden Material.

Gemäß der Erfindung besteht dass das Durchstrahlelement aus einem für die Anregungsstrahlung intransparenten oder nicht transparenten Material besteht. Gemäß der Erfindung sind in dem Durchstrahlelement mehrere Durchgangsaussparungen eingebracht, durch die dann die Anregungsstrahlung strahlen kann. Mit anderen Worten ist das das Konversionselement umgebene Durchstrahlelement zumindest durch Kanäle oder Durchbrüche teiltransparent für das anregende Spektrum.

In weiterer Ausgestaltung der Erfindung ist denkbar, dass die Durchgangsaussparung oder die Durchgangsaussparungen ein Füllmaterial aufweisen. Das Füllmaterial kann dann für die Anregungsstrahlung transparent oder semitransparent und/oder streuend sein.

Die Transmission oder Teiltransmission der Anregungsstrahlung durch das Durchstrahlelement kann vorteilhafterweise dazu führen, das diese die von dem Konversionselement konvertierte Anregungsstrahlung überlagert, was eine Homogenisierung des Farbeindrucks über dem Ort auf der Auskoppelfläche des LARP Systems und über dem Betrachtungswinkel verbessert.

In weiterer Ausgestaltung hat das Konversionselement, insbesondere etwa in einer das Konversionselement schneidenden Ebene, die sich etwa quer zur Hauptabstrahlrichtung erstrecken kann, eine von einer Kreisform abweichende Form. Somit ist vorteilhafterweise im Randbereich des Konversionselements im Vergleich zu einem vollständig kreisförmigen Konversionselement insgesamt weniger Material vorgesehen. Mit anderen Worten ist die Begrenzungslinie des Konversionselements oder eine Umfangswandung des Konversionselements, die die Einkoppelfläche bzw. die Auskoppelfläche umgreift, derart ausgestaltet, dass im Umfangsbereich des Leuchtstoffs gezielt weniger Flächensegmente vorgesehen sind, die eine konvertierte Anregungsstrahlung emittieren. Somit kann im Randbereich des Konversionselements gezielt weniger konvertierte Strahlung emittiert werden, was wiederum zu einer verbesserten Homogenisierung des Farbeindrucks über die Auskoppelfläche des LARP Systems und über dem Betrachtungswinkel führt. Das Konversionselement kann somit etwa in der sich quer zur Hauptabstrahlrichtung erstreckenden Ebene abschnittsweise radial zurückgestuft sein und/oder eine wellenförmige oder sternförmige Begrenzungslinie aufweisen. Alternativ oder zusätzlich ist denkbar, dass das Konversionselement im Randbereich eine Aussparung oder mehrere Aussparungen aufweist. Die Anzahl und/oder die Größe der Aussparungssegmente kann mit zunehmendem Abstand von Zentrum des Konversionselements variieren bzw. den Bedürfnissen entsprechen ausgewählt werden. Alternativ oder zusätzlich ist auch denkbar, dass das Konversionselement zumindest abschnittsweise eine zum Rand hin abnehmende Dicke aufweist. Die Dicke kann hierbei mit zunehmenden Abstand zur Mitte insbesondere gleichmäßig abnehmen. Denkbar ist hierbei, dass die Dicke erst ab einem bestimmten Abstand zur Mitte des Konversionselements abnimmt. Alternativ oder zusätzlich ist auch denkbar, dass das Konversionselement eine kreissegmentförmige Abfolge von Leuchtstoffbereichen aufweist oder daraus gebildet ist, die in einer konzentrischen Abfolge um die optische Achse (hier zusammenfallend mit der Einstrahlrichtung der Laserstrahlung) herum angeordnet sind, also zwiebelschalenförmig. Dabei können die jeweiligen Schichtdicken und/oder Materialeigenschaften, zum Beispiel eine Dotierung mit strahlungskonvertierenden Substanzen, der verschiedenen konzentrisch angeordneten Kreissegmenten, variiert und gemäß den Anforderungen eingestellt werden. So kann zum Beispiel durch unterschiedliche Dotierungen der Konversionsgrad der Segmentringe so eingestellt werden, dass er von innen nach außen abnimmt, also die inneren Kreissegmentringe stärker konvertieren als die äußeren. Auch die gegenläufige Anordnung ist denkbar (innen weniger konvertierend als außen), sowie auch beliebige Einstellungen. Auch können die jeweiligen Kreissegmentringe aus unterschiedlichen Kreissegmentringabschnitten zusammen gesetzt sein, die ebenfalls in der vorgennannten Art und Weise unterschiedliche Eigenschaften aufweisen können, insbesondere auch eine in Umlaufrichtung variierende Dotierung. Bei einer bevorzugten Ausführungsform ist das Konversionselement oder sind das Konversionselement und das Durchstrahlelement von einer für die Anregungsstrahlung intransparenten oder nicht transparenten Struktur oder Beschränkungsstruktur umfangsseitig oder vom Rand her umfasst. Somit strahlt die Anregungsstrahlung in einem definierten Bereich durch das LARP System. Die Struktur kann zumindest teilweise oder im Wesentlichen oder vollständig beispielsweise aus einem optisch intransparenten Material bestehen, beispielsweise aus einer metallischen Beschichtung, zum Beispiel Aluminiumoxid. Vorzugsweise umfasst die Struktur das Konversionselement oder das Durchstrahlelement vollständig. Denkbar ist auch, dass das Konversionselement oder das Konversionselement zusammen mit dem Durchstrahlelement in der Struktur gehaltert sind.

In bevorzugter Weise überdeckt der zentrale Anregefleck sowohl das Konversionselement als auch das Durchstrahlement bzw. die Durchstrahlelemente vollflächig. Damit wird eine besonders hohe Homogenität des Nutzlichts erreicht.

Optional ist strahlungsaustrittsseitig und/oder strahlungseintrittsseitig eine Apertur vorgesehen. Diese ist beispielsweise als Maske ausgebildet. Hierdurch kann unerwünschte Strahlung, die beispielsweise von der Struktur emittiert ist, aufgefangen werden. Mit Vorteil ist die Apertur auf der Struktur angeordnet. Ein Öffnungsquerschnitt der Apertur ist vorzugsweise etwa gleich oder größer als das Konversionselement oder, falls ein Durchstrahlelement vorgesehen ist, als das Durchstrahlelement. Die Apertur kann plattenförmig und/oder ringförmig und/oder freiförmig ausgestaltet sein.

Vorzugsweise liegt die Auskoppelfläche und/oder die Einkoppelfläche für die Strahlung des Konversionselements etwa in einer Ebene mit einer Strahlungsaustrittsfläche und/oder einer Strahlungseintrittsfläche des Durchstrahlelements. Eine Auskoppelfläche und/oder Einkoppelfläche für die Strahlung des Konversionselements kann des Weiteren etwa in einer Ebene mit einer oder einer jeweiligen Stirnfläche der Beschränkungsstruktur liegen.

Das Konversionselement oder das Konversionselement zusammen mit dem Durchstrahlelement kann/können eine Einkoppelseite und eine Auskoppelseite für die Strahlung aufweisen, womit dies oder diese durchstrahlbar sind. Alternativ ist denkbar, dass das Konversionselement oder das Konversionselement zusammen mit dem Durchstrahlelement eine Seite hat/haben, die als Einkoppelseite und als Auskoppelseite dient. Hierbei ist das Konversionselement oder das Konversionselement zusammen mit dem Durchstrahlelement beispielsweise auf einem reflektierenden Element angeordnet. Dies wird auch als ein reflektives LARP-System bezeichnet.

Das LARP System ist vorzugsweise derart ausgestaltet, dass die Anregungsstrahlung teilweise konvertiert ist. Als Strahlungsquelle für die Anregungsstrahlung können beispielsweise eine oder mehrere Laserdioden vorgesehen sein, zum Beispiel im Wellenlängenbereich 405 bis 460 nm. Das LARP System ist vorzugsweise für einen Fahrzeugscheinwerfer oder beispielsweise für ein Head-Up-Display vorgesehen. Denkbar ist auch das LARP System für Projektionsanwendungen einzusetzen, so zum Beispiel in der Kinoprojektion, aber auch als Lichtquelle in Effektscheinwerfern, in der Studiobeleuchtung, in der medizinische Beleuchtung, zur medizinischen Strahlungsbehandlung, und viele andere.

Im Folgenden soll die Offenbarung anhand von Ausführungsbeispielen näher erläutert werden. Die Figuren zeigen:
- Fig. 1: In einem schematischen Längsschnitt ein Laser Activated Remote Phosphor (LARP) System gemäß einem ersten Ausführungsbeispiel,
- Fig. 2: in einer Draufsicht das LARP System aus Figur 1 und
- Fig. 3 und 4: jeweils in einer Draufsicht ein LARP System gemäß einem weiteren Ausführungsbeispiel (Fig. 3) und einem Ausführungsbeispiel gemäß der Erfindung (Fig. 4).

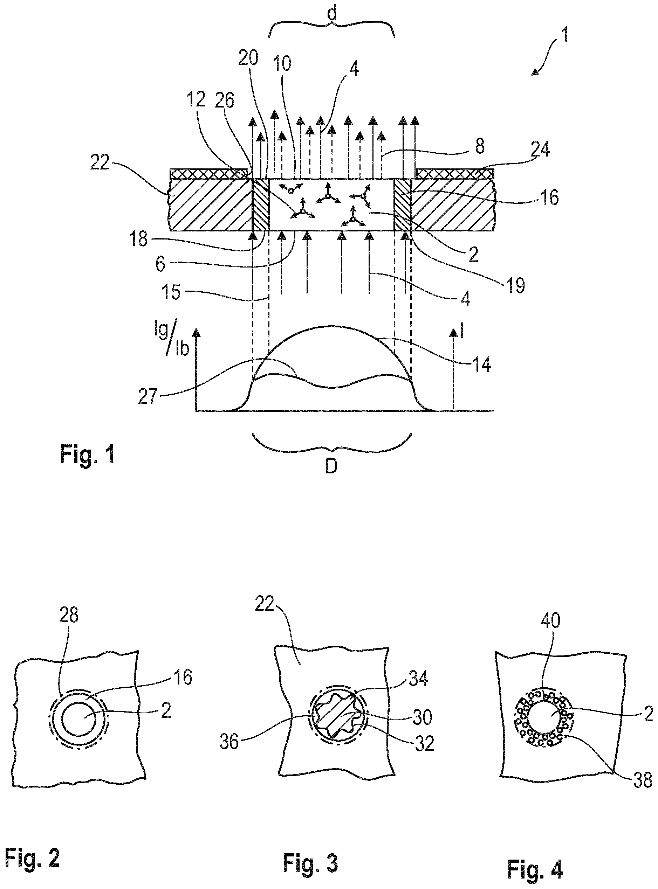

Gemäß Figur 1 hat ein LARP System 1 ein Konversionselement 2. Dieses ist von Anregungsstrahlung 4 einer nicht dargestellten Strahlungsquelle oder Pumplichtquelle bestrahlbar, die über eine Einkoppelfläche 6 des Konversionselements 2 in dieses strahlt. Ein Teil der Anregungsstrahlung 4, bei dem es sich beispielsweise um blaues Laserlicht handeln kann, wird vom Leuchtstoff im Konversionselement 2 teilweise in Konversionsstrahlung 8 konvertiert. Die Konversionsstrahlung 8 zusammen mit unkonvertierter Anregungsstrahlung 4 bilden ein Nutzlicht, das aus einer Auskoppelfläche 10 des Konversionselements 2 austritt. Im Konversionselement 2 wird die Anregungsstrahlung 4 und die Konversionsstrahlung 8 gestreut, was durch Pfeile 12 gezeigt ist.

Gemäß Figur 1 ist eine Intensitätsverteilung 14 (I) der Anregungsstrahlung 4 gezeigt. Sie ist dabei nur in einer Ebene dargestellt, wobei die Intensitätsverteilung 14 in anderen Ebenen, in denen sich die Hauptabstrahlachse der Strahlungsquelle erstreckt, etwa entsprechend ausgebildet ist. Aus der Figur 1 kann somit ein Durchmesser D eines zentralen Anregeflecks der Strahlungsquelle entnommen werden. Der Durchmesser D definiert hier somit die Ausdehnung des zentralen Anregeflecks. Es ist erkennbar, das der Durchmesser D größer als ein Durchmesser d des Konversionselements 2 ist, womit eine Homogenität des aus der Auskoppelfläche 10 austretenden Nutzlichts im Vergleich zum Stand der Technik verbessert ist. Der Durchmesser D beträgt hier 300 µm oder etwa 300 µm.

Gemäß Figur 1 hat das scheibenförmige Konversionselement 2 eine äußere Begrenzungslinie 15 und wird von einem ringförmigen Durchstrahlelement 16 umfasst. Dieses hat etwa einen kreisringförmigen Querschnitt. Eine Lichteintrittsfläche 18 des Durchstrahlelements 16 liegt hierbei etwa in einer Ebene mit der Einkoppelfläche 6, und weist eine äußere Begrenzungslinie 19 auf. Des Weiteren liegt eine Lichtaustrittsfläche 20 des Durchstrahlelements 16 etwa in einer Ebene mit der Auskoppelfläche 10. Das Durchstrahlelement 16 ist für die Anregungsstrahlung 4 transparent oder teiltransparent ausgebildet. Somit kann die Anregungsstrahlung 4 durch das Durchstrahlelement 16 strahlen. Dies ist insbesondere dadurch ermöglicht, dass der zentrale Anregefleck mit dem Durchmesser D einen größeren Durchmesser als das Konversionselement 2 hat und dieses somit überstrahlt. Durch die durch das Durchstrahlelement 16 strahlende Anregungsstrahlung 4 ist das aus dem LARP System 1 austretende Nutzlicht weiter homogenisiert.

Das Durchstrahlelement 16 ist wiederum von einer Beschränkungsstruktur 22 umfasst. Diese ist vorzugsweise für die Anregungsstrahlung 4 intransparent ausgebildet.

Auf der etwa plattenförmigen Beschränkungsstruktur 22 ist auf Seiten der Auskoppelfläche 10 eine Maske 24 oder Blendenstruktur mit einer Öffnung 26 angeordnet. Die Öffnung 26 hat hierbei einen gleichen oder größeren Durchmesser, als ein Durchmesser des Durchstrahlelements 16. Mit der Maske 24 kann insbesondere eine mögliche von der Beschränkungsstruktur 22 emittierte Strahlung beschränkt werden. Alternativ oder zusätzlich ist denkbar, eingangsseitig eine solche Beschränkungsstruktur vorzusehen (ohne Abbildung).

Gemäß Figur 1 ist auch ein Verhältnis der Intensitätsverteilung von gelber Konversionsstrahlung (Ig) zu blauer nicht konvertierter Anregungsstrahlung (Ib) ausgangsseitig des LARP Systems 1 schematisch eingezeichnet, siehe Linie 27. Im Mittenbereich ist der Blau-Anteil höher, im Außenbereich der Gelb-Anteil. Gemäß Figur 2 ist erkennbar, dass das Konversionselement 2 im Querschnitt gesehen etwa kreisförmig ausgestaltet ist. Das Durchstrahlelement 16 ist dabei im Querschnitt gesehen etwa kreisringförmig bzw. kreissegmentringförmig ausgestaltet. Die Strichpunktlinie 28 zeigt dabei etwa den möglichen Austrittsbereich der Strahlung auf. Der zentrale Anregefleck D (nicht dargestellt) der Anregungsstrahlung überstreicht dabei das ganze Konversionselement 2 vollflächig und das kreissegmentringförmige Durchstrahlelement 16 zumindest teilflächig.

Gemäß Figur 3 hat ein Konversionselement 30 eine etwa wellenförmige oder sternförmige Außenkontur 32. So ein Konversionselement kann zum Beispiel durch Sintern, Formpressen oder Stanzen hergestellt werden. Hierdurch ist im Randbereich eine Leuchtstoffmenge im Vergleich zu einem kreisförmigen Konversionselement reduziert. Das Konversionselement 30 weist somit gemäß Figur 3 an seinem Außenumfang oder seiner Außenmantelfläche Zacken 34 oder Vorsprünge auf. Des Weiteren ist das Konversionselement 30 von einem Durchstrahlelement 36 umfasst, das mit seiner Innenkontur an die Außenkontur 32 angepasst ist. Konversionselement 30 und Durchstrahlelement 36 können dabei zum Beispiel verklebt oder versintert oder verpresst sein. Eine Außenkontur des Durchstrahlelements 36 ist entsprechend der Figur 1 etwa kreisförmig und von der Beschränkungsstruktur 22 umgriffen. Auch hier überstreicht der zentrale Anregefleck D (nicht dargestellt) der Anregungsstrahlung das Konversionselement 30 vollflächig und das Durchstrahlelement 36 zumindest teilflächig.

In Figur 4 ist das Konversionselement 2 mit der etwa kreisförmigen Querschnittsform gezeigt. Dieses ist von einem Durchstrahlelement 38 umfasst, das ringförmig oder kreisringförmig ausgestaltet ist. Dieses besteht dabei aus einem für die Anregungsstrahlung nicht transparenten Material. Allerdings sind in das Durchstrahlelement 38 eine Vielzahl von Durchgangsaussparungen 40 eingebracht, die sich etwa in Richtung der Anregungsstrahlung erstrecken und durch die dann die Anregungsstrahlung strahlen kann. Die Durchgangsaussparungen 40 können dabei zum Beispiel bereits beim Sintern eines Keramik-Konversionselements eingebracht werden, oder durch nachträgliche Laserablation. Auch hier überstreicht der zentrale Anregefleck D (nicht dargestellt) der Anregungsstrahlung das Konversionselement 2 ganzflächig und das Durchstrahlelement 40 zumindest teilflächig.

Offenbart ist ein Laser Activated Remote Phosphor (LARP) System mit einer Strahlungsquelle, die eine Anregungsstrahlung emittiert. Zur Teilkonversion der Anregungsstrahlung ist ein Konversionselement mit einem Leuchtstoff vorgesehen. Ein Durchmesser eines zentralen Anregeflecks der Anregungsstrahlung ist hierbei größer als ein Durchmesser des Konversionselements.

**BEZUGSZEICHENLISTE**

| | |
|---|---|
| Laser Activated Remote Phosphor System | 1 |
| Konversionselement | 2 |
| Anregungsstrahlung | 4 |
| Einkoppelfläche | 6 |
| Konversionsstrahlung | 8 |
| Auskoppelfläche | 10 |
| Pfeile | 12 |
| Strahlungsintensität | 14 |
| Begrenzungslinie | 15 |
| Durchstrahlelement | 16 |
| Lichteintrittsfläche | 18 |
| Begrenzungslinie | 19 |
| Lichtaustrittsfläche | 20 |
| Beschränkungsstruktur | 22 |
| Maske | 24 |
| Öffnung | 26 |
| Linie | 27 |
| Strich-Punkt-Linie | 28 |
| Konversionselement | 30 |
| Außenkontur | 32 |
| Zacken | 34 |
| Durchstrahlelement | 36 |
| Durchstrahlelement | 38 |
| Durchgangsaussparungen | 40 |

## Patentansprüche

1. Laser Activated Remote Phosphor (LARP) System mit einer Strahlungsquelle, über die Anregungsstrahlung (4) emittierbar ist, und mit einem Konversionselement (2; 30), das einen Leuchtstoff aufweist und von der Anregungsstrahlung (4) bestrahlbar ist, wobei eine Einkoppelfläche (6) des Konversionselements (2) eine Begrenzungslinie (15) hat, die ein zentraler Anregefleck der Anregungsstrahlung (4) zumindest abschnittsweise überstrahlt, **dadurch gekennzeichnet, dass** das Konversionselement (2) eine etwa kreisförmige Querschnittsform hat, wobei das Konversionselement (2) von einem Durchstrahlelement (38) umfasst ist, das ringförmig oder kreisringförmig ausgestaltet ist und aus einem für die Anregungsstrahlung nicht transparenten Material besteht, wobei in das Durchstrahlelement (38) eine Vielzahl von Durchgangsaussparungen (40) eingebracht sind, die sich etwa in Richtung der Anregungsstrahlung (4) erstrecken und durch die die Anregungsstrahlung (4) strahlen kann, und wobei der zentrale Anregefleck der Anregungsstrahlung das Konversionselement (2) ganzflächig und das Durchstrahlelement (38) zumindest teilflächig überstreicht.

2. LARP System nach Anspruch 1, wobei der zentrale Anregefleck das Durchstrahlelement (16; 36; 38) vollständig überdeckt.

3. LARP System nach einem der vorhergehenden Ansprüche, wobei das Konversionselement (2; 30) oder das Konversionselement (2; 30) zusammen mit dem Durchstrahlelement (16; 36; 38) von einer für die Anregungsstrahlung (4) intransparenten Beschränkungsstruktur (22) umfangsseitig umfasst ist/sind.

4. LARP System nach einem der vorhergehenden Ansprüche, wobei strahlungsaustrittsseitig oder strahlungseintrittsseitig eine Apertur (24) vorgesehen ist.

5. LARP System nach Anspruch 4, wobei die Apertur (24) auf der Beschränkungsstruktur (22) angeordnet ist.

6. LARP System nach einem der vorhergehenden Ansprüche, wobei bei einem Nutzlicht ausgangsseitig des LARP Systems (1) ein Verhältnis einer Intensitätsverteilung von gelber Konversionsstrahlung (Ig) zu blauer nicht konvertierter Anregungsstrahlung (Ib) etwa quer zur Hauptabstrahlachse gesehen mittig geringer ist, wobei insbesondere das Verhältnis etwa quer zur Hauptabstrahlachse gesehen eine Farb-Varianz von kleiner oder gleich 20% aufweist oder wobei insbesondere das Verhältnis etwa quer zur Hauptabstrahlachse gesehen eine Farb-Varianz von kleiner oder gleich 10% aufweist oder wobei insbesondere das Verhältnis etwa quer zur Hauptabstrahlachse gesehen eine Farb-Varianz von kleiner oder gleich 5% aufweist.

7. Fahrzeugscheinwerfer mit einem LARP System gemäß einem der vorhergehenden Ansprüche.

## Claims

1. Laser activated remote phosphor (LARP) system having a radiation source that can emit excitation radiation (4) and having a conversion element (2; 30) which has a phosphor and is able to be irradiated by the excitation radiation (4), wherein an input coupling surface (6) of the conversion element (2) has a delimitation line (15) beyond which a central excitation spot of the excitation radiation (4) radiates at least in sections, **characterized in that** the conversion element (2) has an approximately circular cross-sectional shape, wherein a light-passage element (38), which has an annular or circle-ring-shaped design and consists of a material that is not transparent for the excitation radiation, engages around the conversion element (2), wherein a multiplicity of through-cutouts (40) are provided in the light-passage element (38), which through-cutouts (40) extend approximately in the direction of the excitation radiation (4) and through which the excitation radiation (4) can radiate, and wherein the central excitation spot of the excitation radiation sweeps over the entire surface of the conversion element (2) and at least over some of the surface of the light-passage element (38).

2. LARP system according to Claim 1, wherein the central excitation spot completely covers the light-passage element (16; 36; 38).

3. LARP system according to either of the preceding claims, wherein a confinement structure (22), which is opaque for the excitation radiation (4), engages around the perimeter side of the conversion element (2; 30), or around the conversion element (2; 30) together with the light-passage element (16; 36; 38).

4. LARP system according to one of the preceding claims, wherein an aperture (24) is provided on the radiation exit side or the radiation entry side.

5. LARP system according to Claim 4, wherein the aperture (24) is arranged on the confinement structure (22).

6. LARP system according to one of the preceding claims, wherein in used light on the exit side of the LARP system (1) a ratio of an intensity distribution of yellow conversion radiation (Ig) to blue, unconverted excitation radiation (Ib) viewed approximately transversely with respect to the main emission axis is centrally lower, wherein in particular the ratio viewed approximately transversely with respect to the main emission axis has a color variance of less than or equal to 20%, or wherein in particular the ratio viewed approximately transversely with respect to the main emission axis has a color variance of less than or equal to 10%, or wherein in particular the ratio viewed approximately transversely with respect to the main emission axis has a color variance of less than or equal to 5%.

7. Vehicle headlight having a LARP system according to one of the preceding claims.

## Revendications

1. Système de phosphore activé à distance par laser (LARP) comprenant une source de rayonnement par laquelle un rayonnement d'excitation (4) peut être émis et un élément de conversion (2, 30) qui comporte une substance luminescente et peut être irradié par le rayonnement d'excitation (4), dans lequel une surface d'introduction (6) de l'élément de conversion (2) possède une ligne de délimitation (15), qu'un spot d'excitation central du rayonnement d'excitation (4) irradie au moins en partie, **caractérisé en ce que** l'élément de conversion (2) a une coupe transversale de forme approximativement circulaire, dans lequel l'élément de conversion (2) est entouré par un élément de rayonnement traversant (38) qui a une forme annulaire ou d'anneau circulaire et qui est constitué d'un matériau non transparent au rayonnement d'excitation, dans lequel élément de rayonnement traversant (38) une pluralité d'évidements de passage (40) sont agencés, lesquels s'étendent approximativement en direction du rayonnement d'excitation (4) et à travers lesquels le rayonnement d'excitation (4) peut diffuser, et dans lequel le spot d'excitation central du rayonnement d'excitation balaie l'élément de conversion (2) sur toute sa surface et l'élément de rayonnement traversant (38) sur au moins une partie de sa surface.

2. Système LARP selon la revendication 1, dans lequel le spot d'excitation central couvre complètement l'élément de rayonnement traversant (16, 36, 38).

3. Système LARP selon l'une des revendications précédentes, dans lequel l'élément de conversion (2, 30) ou l'élément de conversion (2, 30) ainsi que l'élément de rayonnement traversant (16, 36, 38) est/sont entouré(s) sur leur pourtour par une structure de délimitation (22) non transparente au rayonnement d'excitation (4).

4. Système LARP selon l'une des revendications précédentes, dans lequel une ouverture (24) est agencée du côté de la sortie du rayonnement ou du côté de l'entrée du rayonnement.

5. Système LARP selon la revendication 4, dans lequel l'ouverture (24) est disposée sur la structure de délimitation (22).

6. Système LARP selon l'une quelconque des revendications précédentes, dans lequel, dans une lumière utile du côté sortie du système LARP (1), un rapport de distribution d'intensité du rayonnement de conversion jaune (Ig) au rayonnement d'excitation non converti bleu (Ib) est plus faible au milieu, vu approximativement transversalement à l'axe de rayonnement principal, notamment dans lequel le rapport présente, vu approximativement transversalement à l'axe principal de rayonnement, une variance de couleur inférieure ou égale à 20 % ou notamment dans lequel le rapport présente, vu approximativement transversalement à l'axe principal de rayonnement, une variance de couleur inférieure ou égale à 10 % ou notamment dans lequel le rapport présente, vu approximativement transversalement à l'axe principal de rayonnement, une variance de couleur inférieure ou égale à 5 %.

7. Phare pour véhicule comprenant un système LARP selon l'une des revendications précédentes.
